# EUROPEAN PATENT SPECIFICATION

(11) **EP 2 554 022 B1**
(45) Date of publication and mention of the grant of the patent: **17.10.2018**
(21) Application number: 11714091.3
(22) Date of filing: 31.03.2011
(51) Int. Cl.: H05B 37/02, H03K 17/96

(54) **A DEVICE FOR CONTROLLING AN ELECTRICAL LOAD**
VORRICHTUNG ZUR REGELUNG EINEM ELEKTROLAST
APPAREIL DE REGULATION D'UNE CHARGE ELECTRIQUE

(30) Priority: 01.04.2010 GB 201005578
(43) Date of publication of application: 06.02.2013
(73) Proprietor: CP Electronics Limited, London, Greater London NW10 7XR (GB)
(72) Inventor: MANS, Paul, London Greater London NW10 7XR (GB); MILNER, Merlin, London Greater London NW10 7XR (GB)
(74) Representative: HGF Limited
(86) International application number: PCT/GB2011/050666
(87) International publication number: WO 2011/121364

(56) References cited:
- EP-A2- 1 383 242
- WO-A1-2004/109920
- WO-A1-2006/056814
- WO-A1-2009/141531
- DE-A1- 10 201 746
- GB-A- 2 402 211
- US-A- 4 305 006
- US-A- 4 803 418
- US-A- 6 107 938
- US-B1- 7 122 976
- SensorSwitch: "WALL SWITCH DECORATOR SENSOR PASSIVE INFRARED (PIR), LINE VOLTAGE, w/ NIGHT LIGHT, WSD-NL SERIES", , 13 December 2007 (2007-12-13), pages 1-2, XP55004032, Wallingford, CT, USA Retrieved from the Internet: URL:http://www.sensorswitch.com/DataSheets /WSD-NL.pdf [retrieved on 2011-08-02]
- Schneider Electric: "Products Guide: Lighting Control and Integrated Home Systems", , 1 January 2010 (2010-01-01), pages 1-166, XP55004035, La Vergne, TN, USA [retrieved on 2011-08-02]

## Description

This invention relates to a device for controlling an electrical load and to a method of calibrating such a device.

### BACKGROUND

The prior art discloses many devices for controlling electrical loads. In particular, there are many light switches that allow lighting to be controlled in response to a variety of inputs. For example, some light switches comprise a passive infra-red receiver (PIR) or microwave presence/absence detector which can switch on the lights when a person enters the room or space in which the switch is located and can switch off the lights when the person leaves.

There are currently available control products that detect whether a space is occupied using a number of sensing means (passive infra-red (PIR), microwave, ultrasonics etc.). This detection is then used to turn on a load, typically lighting. When an area is no longer occupied the load turns off. There are two methods used: absence detection (manual on, auto off) and presence detection (auto on, auto off). Absence detection normally uses a switch, either integral to the detector or mounted separately to signal that the load is required to be switched on; whilst presence detection automatically turns on but can have an optional override switch to turn the load off when not required.

Some light switches include a remote control that can be used to control the lighting remotely. Sensor Switch, Inc. of Wallingford, CT, USA provide a "NightLite Sensor" in their WSD-NL Series of products. GB 2402211A discloses an occupancy sensor based on a microwave transmitter and receiver.

### BRIEF SUMMARY OF THE DISCLOSURE

Viewed from a first aspect, the invention provides a device for controlling an electrical load, such as lighting, according to independent claim 1.

Thus, according to this aspect of the invention, the device can switch on the load manually and at the same time switch on the presence/absence detector. When the presence/absence detector identifies that there is no longer anyone present in the area of operation of the device, the device switches the load and the presence/absence detector off. In this way, it is not necessary for the absence/presence detector to be powered when the load is off and this results in a lower standby power consumption for the device. This is particularly important where the presence/absence detector is a microwave detector.

The manually operable control may be a simple switch, a capacitive sensor or the like. The manually operable control may be remote from the presence/absence detector. In the preferred embodiment, the manually operable control comprises a proximity sensor responsive to the presence of a hand within the detection range of the proximity sensor.

Thus, the presence/absence detector is accompanied by a relatively short range proximity detector. This allows the device according to embodiments of the invention to be operated manually or automatically without any moving parts, with a completely sealed housing and with gloved hands (unlike known capacitive sensors). This solution is ideal for many working environments where a traditional light switch or presence/absence detector would not provide the operational flexibility of the present invention.

As used herein, "switching" of the load does not exclude dimming or switching the load between two levels, for example switching lighting between low level emergency lighting and a fully illuminated level. Thus the device of the present invention may comprise a dimmer for controlling a lighting load. In embodiments of the invention, the device is a light switch, including the possibility that the light switch is capable of dimming the lighting load.

The device of the invention may be programmable to operate in multiple modes of operation selectable by the user. Provided that at least one of these modes is in accordance with the present invention, the device is considered to be within the scope of the present invention.

In the preferred embodiment, the load controlled by the device is a lighting load. However, the device may be used to control other electrical loads, for example an environment control (air conditioning) system.

In embodiments of the invention, the proximity sensor comprises an infra-red emitter configured to emit infra-red radiation and an infra-red receiver configured to receive infra-red radiation reflected by an object, such as a hand, within the detection range of the proximity, whereby to detect the presence of a hand within the detection range. Such sensors are known per se.

The presence/absence detector comprises a microwave transmitter and a microwave receiver. "Presence detection" refers to the determination that a person (or persons) has entered or continues to occupy the detection region. "Absence detection" refers to the determination that a person (or persons) has ceased to occupy the detection region.

In embodiments of the invention, the detection range of the presence/absence detector is at least ten times the detection range of the proximity sensor. Preferably, the detection range of the presence/absence detector is at least 100 times the detection range of the proximity sensor. The detection range of the presence/absence detector is feasibly at least 1,000 times the detection range of the proximity sensor.

In an embodiment of the invention, the device comprises a proximity sensor responsive to the presence of a hand within the detection range of the proximity sensor, and a remote control for the device. The remote control is capable of wirelessly sending control information to the device and wirelessly receiving control information from the device. The proximity sensor comprises an infra-red emitter configured to emit infra-red radiation and an infra-red receiver configured to receive infra-red radiation reflected by an object, such as a hand, within the detection range of the proximity sensor, whereby to detect the presence of a hand within the detection range. The remote control comprises a remote infra-red emitter and a remote infra-red receiver for, respectively, sending and receiving control information to and from the device. The infra-red emitter of the proximity sensor is configured to send control information to the remote infra-red receiver of the remote control and/or the infra-red receiver of the proximity sensor is configured to receive control information from the remote infra-red emitter.

Thus, the same infra-red receiver or emitter can be used both for the remote control and the proximity sensor. In this way, the cost and complexity of the device can be reduced.

It is feasible that this feature could be applied to embodiments in which the remote control is only sends information to the device, and does not receive, and a common receiver is used at the device for both the remote control and the proximity sensor.

The infra-red emitter of the proximity sensor may be configured to operate at a first output power level for proximity sensing and a second output power level for communication with the remote control, wherein the second output power level is higher than the first output power level. In this way, power usage is kept to a minimum in the event that the remote control is not in use.

The infra-red emitter may be configured to emit pulses of infra-red radiation and the device may be configured to count the number of reflected pulses received by the infra-red receiver within a predefined period of time and to determine the presence of a hand within the detection range if the number of reflected pulses received within the predefined period exceeds a predefined number.

Thus, a simple counting method is used to reduce the effect of spurious reflections of the infra-red radiation on the proximity sensor. By "counting" is meant any method that is indicative of the rate at which pulses are reflected successfully by an object. It is not necessary for an exact number of pulses to be calculated, provided an indication of successful reflection is achieved.

In an embodiment of the invention, the device further comprises a housing, a cover plate which covers the front of the housing and has defined therein a window for the passage of infra-red radiation from the infra-red emitter, and a shield member arranged, in use, within the housing to prevent the direct transmission of infra-red radiation from the infra-red emitter to the infra-red receiver. The shield member is mounted directly to the cover plate.

Thus, the shield member is mounted to the cover plate, which enables accurate location of the shield member relative to the cover plate. This is important to prevent leakage of light.

Preferably the shield member forms a light-tight seal at the cover plate. This may be achieved by bonding the shield member to the cover plate. Preferably, however, the shield member is formed, for example moulded, integrally with the cover plate.

The shield member may take any suitable form, for example a plate or panel. In the preferred embodiment the shield member is tubular. The shield member may be configured to surround the infra-red emitter, in use.

In a preferred embodiment, at least a portion of the shield member partitions the window into a section for emission of infra-red radiation and a section for receipt of infrared radiation. In this way, a single window may be provided, which may be aesthetically and structurally desirable.

The window may be covered by a single piece of transparent material, such as a lens. Again this may be aesthetically desirable. "Transparent" in this sense, means sufficiently transparent for effective operation of the proximity sensor.

The cover plate may have only one window defined therein. Again this may be aesthetically desirable.

### BRIEF DESCRIPTION OF THE DRAWINGS

Embodiments of the invention are further described hereinafter with reference to the accompanying drawings, in which:
Figure 1 is a schematic block diagram of light switching device according to an embodiment of the invention; and
Figure 2 is a sectional view of a detail of a light switching device according to an embodiment of the invention.

### DETAILED DESCRIPTION

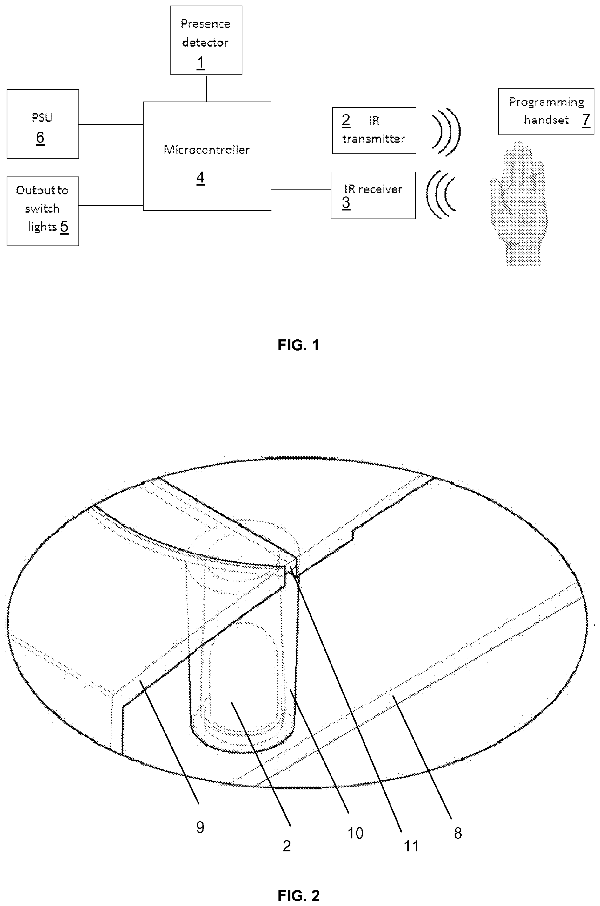

Figure 1 shows a device for controlling electrical lighting according to an embodiment of the invention. The device comprises a presence detector 1 in the form of a microwave detector, which is responsive to the presence of a person within the detection range of the detector. In addition to the presence detector 1, the device comprises a proximity sensor in the form of an infra-red transmitter 2 and an infra-red receiver 3. A hand within the detection range of the proximity sensor will reflect pulses of infra-red radiation from the IR transmitter 2 back to the IR receiver 3. By counting the number of reflected pulses it is possible to determine whether or not there is an object in the vicinity of the proximity sensor.

A microcontroller 4 receives the outputs of the presence detector 1 and the IR receiver 3, and controls an output 5 to a lighting circuitry. The entire device is powered by a power supply 6. In one mode of operation, the device is configured to switch on the load 6 in response to detection of the presence of a person by the presence detector 1 and switch off the load 5 in response to the sensing of the presence of a hand by the proximity sensor 2, 3. In a different mode of operation, the device is configured to switch on the load 5 in response to the sensing of the presence of a hand by the proximity sensor 2, 3 and switch off the load 5 in response to the detection of the absence of a person by the presence detector 1.

In this way, the IR transmitter 2 and receiver 3 act as a manual control in combination with the presence detector 1. It would be possible, in a further mode of operation, for the proximity sensor 2, 3 to operate as a simple on/off switch, if desired or for the device to operate fully automatically under the control of the presence detector 1.

In a further mode of operation, the device is configured to switch on the load 5 and the presence detector 1 in response to detection of a hand by the proximity sensor 2, 3 and to switch off the load 5 and the presence detector 1 in response to the detection of the absence of a person by the presence detector. In this way, the presence detector 1 is not powered when the load 5 is off and this results in a lower standby power consumption for the device. This is particularly important where the presence detector 1 is a microwave detector.

As shown in Figure 1, the device comprises a remote control 7. The remote control 7 is capable of wirelessly sending control information to the device and wirelessly receiving control information from the device. The infra-red transmitter of the proximity sensor 2 is configured to send control information to the infra-red receiver of the remote control 7and the infra-red receiver 3 of the proximity sensor is configured to receive control information from the infra-red emitter of the remote control 7. The remote control 7 can be used to program the mode of operation of the device.

The infra-red emitter 2 of the proximity sensor is configured to operate at a low output power level for proximity sensing and a higher output power level for communication with the remote control 7. The programming handset 7 is normally operated at a long distance away from the unit. Hence a relatively high power infrared signal is needed. Because the infrared receiver 3 is in the same unit as the transmitter 2, a much lower power is needed to detect reflectance. Not only does this minimise the power consumption of the unit, but it overcomes problems with internal reflections of infrared signals. This product incorporates circuitry which drives the infrared emitter from two different sources depending on the power level required.

As described above, the microcontroller 4 controls the infra-red transmitter 2 to emit pulses of infra-red radiation and counts the number of reflected pulses received by the infra-red receiver 3 within a predefined period of time. The microcontroller 4 determines the presence of a hand within the detection range if the number of reflected pulses received within the predefined period exceeds a predefined number.

As shown in Figure 2, the device further comprises a housing 8, a cover plate 9 which covers the front of the housing and has defined therein a window for the passage of infra-red radiation from the infra-red emitter 2. A tubular shield member 10 is arranged within the housing to prevent the direct transmission of infra-red radiation from the infra-red emitter 2 to the infra-red receiver 3. The shield member is moulded integrally with the cover plate 9. In this way, the shield member 10 forms a light-tight seal at the cover plate 9. As shown in Figure 2, the shield member partitions the window into a section for emission of infra-red radiation and a section for receipt of infra-red radiation. The window is covered by a single transparent lens 11.

The described device is calibrated by positioning an object at a predefined location within the detection range of the proximity sensor, determining the response of the proximity sensor to the presence of the object and storing data indicative of the response of the proximity sensor in the microcontroller 4.

According to this embodiment, two methods are employed to distinguish between a valid reading and a false reading. Firstly it can be assumed that a hand passing over the unit will be present for a certain amount of time (typically more than 0.25s). So the measured signal is checked for duration and must exceed the time period for validation. Secondly the infrared signal is sent out in pulses: if spurious signals are reflected then only a certain proportion of the pulses will be counted back. Whereas if a proper reflection occurs, a much higher proportion will be reflected. Monitoring the proportion of reflected pulses allows false triggering to be reduced. The tolerances of the electronic components used will vary considerably so this product implements a novel calibration routine which measures the pulse count of a genuine reflected object and the pulse count for spurious internal reflections during a factory setup procedure. These values are then stored in nonvolatile memory so that the product does not need on-site calibration. Typically the proximity sensing will be at a range of about 2cm whilst a typical microwave sensor may have a detection range of 30m.

Throughout the description and claims of this specification, the words "comprise" and "contain" and variations of them mean "including but not limited to", and they are not intended to (and do not) exclude other components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The invention is not restricted to the details of any foregoing embodiments. The invention extends to any novel one, or any novel combination, of the features disclosed in this specification (including any accompanying claims, abstract and drawings), or to any novel one, or any novel combination, of the steps of any method or process so disclosed.

## Claims

1. A device for controlling an electrical load, such as lighting, the device comprising:
a presence or absence detector (1) responsive to the presence of a person within the detection range of the detector; and
a manually-operable control (2, 3),
wherein, in at least one mode of operation, the device is configured to switch on the load in response to the manually-operable control and to switch off the load in response to the detection of the absence of a person by the presence/absence detector
**characterised in that** the presence/absence detector comprises a microwave transmitter and a microwave receiver, and **in that** in the at least one mode of operation the device is further configured to switch on the presence/absence detector in response to the manually-operable control and to switch off the presence/absence detector in response to the detection of the absence of a person by the presence/absence detector.

2. A device as claimed in claim 1, wherein the manually operable control comprises a proximity sensor (2, 3) responsive to the presence of a hand within the detection range of the proximity sensor.

3. A device as claimed in claim 2, wherein the proximity sensor comprises an infra-red emitter (2) configured to emit infra-red radiation and an infra-red receiver (3) configured to receive infra-red radiation reflected by an object, such as a hand, within the detection range of the proximity, whereby to detect the presence of a hand within the detection range.

4. A device as claimed in claim 3, the device further comprising:
a remote control (7) for the device, the remote control being capable of wirelessly sending control information to the device and wirelessly receiving control information from the device,
wherein the remote control comprises a remote infra-red emitter and a remote infra-red receiver for, respectively, sending and receiving control information to and from the device, and
wherein the infra-red emitter (2) of the proximity sensor is configured to send control information to the remote infra-red receiver of the remote control and/or the infrared receiver (3) of the proximity sensor is configured to receive control information from the remote infra-red emitter.

5. A device as claimed in claim 4, wherein the infra-red emitter (2) of the proximity sensor is configured to operate at a first output power level for proximity sensing and a second output power level for communication with the remote control (7), wherein the second output power level is higher than the first output power level.

6. A device as claimed in any of claims 3 to 5, wherein the infra-red emitter (2) is configured to emit pulses of infra-red radiation and the device is configured to count the number of reflected pulses received by the infra-red receiver (3) within a predefined period of time and to determine the presence of a hand within the detection range if the number of reflected pulses received within the predefined period exceeds a predefined number.

7. A device as claimed in any of claims 3 to 6, wherein the device further comprises:
a housing (8);
a cover plate (9) which covers the front of the housing and has defined therein a window for the passage of infra-red radiation from the infra-red emitter (2), and
a shield member (10) arranged, in use, within the housing to prevent the direct transmission of infra-red radiation from the infra-red emitter to the infra-red receiver (3), and
wherein the shield member is mounted directly to the cover plate.

8. A device as claimed in claim 7, wherein the shield member (10) forms a light-tight seal at the cover plate (9).

9. A device as claimed in claim 7 or 8, wherein the shield member (10) is moulded integrally with the cover plate (9).

10. A device as claimed in any of claims 7 to 9, wherein the shield member (10) is tubular.

11. A device as claimed in any of claims 7 to 10, wherein at least a portion of the shield member (10) partitions the window into a section for emission of infra-red radiation and a section for receipt of infra-red radiation.

12. A device as claimed in any of claims 7 to 11, wherein the window is covered by a single piece of transparent material.

13. A device as claimed in any of claims 7 to 12, wherein the cover plate (9) has only one window defined therein.

## Patentansprüche

1. Vorrichtung zum Steuern eines elektrischen Verbrauchers, wie etwa von Beleuchtung, wobei die Vorrichtung folgendes umfasst:
einen Anwesenheits- oder Abwesenheits-Detektor (1), der auf die Anwesenheit einer Person innerhalb des Erkennungsbereichs des Detektors anspricht; und
eine manuell bedienbare Steuerung (2, 3);
wobei Vorrichtung in wenigstens einem Betriebsmodus so gestaltet ist, dass sie den Verbraucher als Reaktion auf die manuell bedienbare Steuerung einschaltet und dass sie den Verbraucher als Reaktion auf die Erkennung der Abwesenheit einer Person durch den Anwesenheits-/Abwesenheits-Detektor ausschaltet;
**dadurch gekennzeichnet, dass** der Anwesenheits-/Abwesenheits-Detektor einen Mikrowellensender und einen Mikrowellenempfänger umfasst, und wobei die Vorrichtung in dem wenigstens einen Betriebsmodus ferner so gestaltet ist, dass sie den Anwesenheits-/Abwesenheits-Detektor als Reaktion auf die manuell bedienbare Steuerung einschaltet und dass sie den Anwesenheits-/Abwesenheits-Detektor als Reaktion auf die Erkennung der Abwesenheit einer Person durch den Anwesenheits-/Abwesenheits-Detektor ausschaltet.

2. Vorrichtung nach Anspruch 1, wobei die manuell bedienbare Steuerung einen Annäherungssensor (2, 3) umfasst, der auf das Vorhandensein einer Hand in dem Erkennungsbereich des Annäherungssensors reagiert.

3. Vorrichtung nach Anspruch 2, wobei der Annäherungssensor einen Infrarotemitter (2) umfasst, der so gestaltet ist, dass er Infrarotstrahlung emittiert, und einen Infrarotempfänger (3), der so gestaltet ist, dass er Infrarotstrahlung empfängt, die von einem Objekt, wie etwa einer Hand, innerhalb des Erkennungsbereichs reflektiert wird, wodurch das Vorhandensein einer Hand in dem Erkennungsbereich erkannt wird.

4. Vorrichtung nach Anspruch 3, wobei die Vorrichtung ferner folgendes umfasst:
eine Fernsteuerung (7) für die Vorrichtung, wobei die Fernsteuerung kabellos Steuerinformationen an die Vorrichtung senden und kabellos Steuerinformationen von der Vorrichtung empfangen kann; und
wobei der Infrarotemitter (2) des Annäherungssensors so gestaltet ist, dass er Steuerinformationen an den entfernten Infrarotempfänger der Fernsteuerung sendet, und/oder wobei der Infrarotempfänger (3) des Annäherungssensors so gestaltet ist, dass er Steuerinformationen von dem entfernten Infrarotemitter empfängt.

5. Vorrichtung nach Anspruch 4, wobei der Infrarotemitter (2) des Annäherungssensors so gestaltet ist, dass er mit einem ersten Ausgangsleistungswert für die Annäherungsmessung arbeitet sowie mi einem zweiten Ausgangsleistungswert für die Kommunikation mit der Fernsteuerung (7), wobei der zweite Ausgangsleistungswert höher ist als der erste Ausgangsleistungswert.

6. Vorrichtung nach einem der Ansprüche 3 bis 5, wobei der Infrarotemitter (2) so gestaltet ist, dass er Infrarotstrahlungsimpulse emittiert, und wobei die Vorrichtung so gestaltet ist, dass sie die Anzahl der innerhalb eines vorbestimmten Zeitraums reflektierten und von dem Infrarotempfänger (3) empfangenen Impulse zählt und das Vorhandensein einer Hand innerhalb des Erkennungsbereichs bestimmt, wenn die Anzahl der innerhalb des vorbestimmten Zeitraums empfangenen reflektierten Impulse eine vordefinierte Anzahl überschreitet.

7. Vorrichtung nach einem der Ansprüche 3 bis 6, wobei die Vorrichtung ferner folgendes umfasst:
ein Gehäuse (8);
eine Abdeckplatte (9), welche die Vorderseite des Gehäuses abdeckt und ein darin definiertes Fenster für den Durchgang von Infrarotstrahlung von dem Infrarotemitter (2) aufweist; und
ein Abschirmungselement (10), das im Einsatz in dem Gehäuse angeordnet ist, um die direkte Übermittlung von Infrarotstrahlung von dem Infrarotemitter zu dem Infrarotempfänger (3) zu verhindern; und
wobei das Abschirmungselement direkt an der Abdeckplatte angebracht ist.

8. Vorrichtung nach Anspruch 7, wobei das Abschirmungselement (10) eine lichtdichte Abdichtung an der Abdeckplatte (9) bildet.

9. Vorrichtung nach Anspruch 7 oder 8, wobei das Abschirmungselement (10) integral mit der Abdeckplatte (9) geformt ist.

10. Vorrichtung nach einem der Ansprüche 7 bis 9, wobei das Abschirmungselement (10) röhrenförmig ist.

11. Vorrichtung nach einem der Ansprüche 7 bis 10, wobei wenigstens ein Teil des Abschirmungselements (10) das Fenster in einen Abschnitt zur Emission von Infrarotstrahlung und einen Abschnitt für den Empfang von Infrarotstrahlung unterteilt.

12. Vorrichtung nach einem der Ansprüche 7 bis 11, wobei das Fenster mit einem Stück aus einem transparenten Material abgedeckt ist.

13. Vorrichtung nach einem der Ansprüche 7 bis 12, wobei die Abdeckplatte (9) nur ein darin definiertes Fenster aufweist.

## Revendications

1. Dispositif pour commander une charge électrique, telle que l'éclairage, le dispositif comprenant :
un détecteur de présence ou d'absence (1) détectant la présence d'une personne dans la plage de détection du détecteur ; et
une commande actionnée manuellement (2, 3),
dans au moins un mode de fonctionnement, le dispositif étant conçu pour allumer la charge en réponse à la commande actionnée manuellement et pour éteindre la charge en réponse à la détection de l'absence d'une personne par le détecteur de présence/absence
**caractérisé en ce que** le détecteur de présence/absence comprend un émetteur hyperfréquence et un récepteur hyperfréquence, et **en ce que** dans l'au moins un mode de fonctionnement, le dispositif est en outre conçu pour mettre sous tension le détecteur de présence/absence en réponse à la commande actionnée manuellement et pour mettre hors tension le détecteur de présence/absence en réponse à la détection de l'absence d'une personne par le détecteur de présence/absence.

2. Dispositif selon la revendication 1, la commande actionnée manuellement comprenant un capteur de proximité (2, 3) détectant la présence d'une main dans la plage de détection du capteur de proximité.

3. Dispositif selon la revendication 2, le capteur de proximité comprenant un émetteur infrarouge (2) conçu pour émettre un rayonnement infrarouge et un récepteur infrarouge (3) conçu pour recevoir un rayonnement infrarouge réfléchi par un objet, tel qu'une main, dans la plage de détection de la proximité, afin de détecter la présence d'une main dans la plage de détection.

4. Dispositif selon la revendication 3, le procédé comprenant en outre :
une télécommande (7) pour le dispositif, la télécommande pouvant envoyer sans fil des informations de commande au dispositif et de recevoir sans fil des informations de commande du dispositif,
la télécommande comprenant un émetteur infrarouge à distance et un récepteur infrarouge à distance pour, respectivement, envoyer et recevoir des informations de commande à destination et en provenance du dispositif, et
l'émetteur infrarouge (2) du capteur de proximité étant conçu pour envoyer des informations de commande au récepteur infrarouge distant de la télécommande et/ou le récepteur infrarouge (3) du capteur de proximité étant conçu pour recevoir des informations de commande de l'émetteur infrarouge distant.

5. Dispositif selon la revendication 4, l'émetteur infrarouge (2) du capteur de proximité étant conçu pour fonctionner à un premier niveau de puissance de sortie pour la détection de proximité et à un second niveau de puissance de sortie pour la communication avec la télécommande (7), le second niveau de puissance de sortie étant supérieur au premier niveau de puissance de sortie.

6. Dispositif selon l'une quelconque des revendications 3 à 5, l'émetteur infrarouge (2) étant conçu pour émettre des impulsions de rayonnement infrarouge et le dispositif étant conçu pour compter le nombre d'impulsions réfléchies reçues par le récepteur infrarouge (3) dans une période de temps prédéfinie et pour déterminer la présence d'une main dans la plage de détection si le nombre d'impulsions réfléchies reçues dans la période prédéfinie dépasse un nombre prédéfini.

7. Dispositif selon l'une quelconque des revendications 3 à 6, le dispositif comprenant en outre :
un boîtier (8) ;
une plaque de recouvrement (9) qui recouvre l'avant du boîtier et dans laquelle est définie une fenêtre pour le passage du rayonnement infrarouge de l'émetteur infrarouge (2), et
un élément de blindage (10) disposé, lors de l'utilisation, à l'intérieur du boîtier pour empêcher l'émission directe du rayonnement infrarouge de l'émetteur infrarouge vers le récepteur infrarouge (3), et
l'élément de blindage étant monté directement sur la plaque de recouvrement.

8. Dispositif selon la revendication 7, l'élément de blindage (10) formant un joint étanche à la lumière au niveau de la plaque de recouvrement (9).

9. Dispositif selon la revendication 7 ou 8, l'élément de blindage (10) étant moulé d'un seul tenant avec la plaque de recouvrement (9).

10. Dispositif selon l'une quelconque des revendications 7 à 9, l'élément de blindage (10) étant tubulaire.

11. Dispositif selon l'une quelconque des revendications 7 à 10, au moins une partie de l'élément de blindage (10) séparant la fenêtre en une section pour l'émission de rayonnement infrarouge et une section pour la réception de rayonnement infrarouge.

12. Dispositif selon l'une quelconque des revendications 7 à 11, la fenêtre étant couverte par une pièce unique de matériau transparent.

13. Dispositif selon l'une quelconque des revendications 7 à 12, la plaque de recouvrement (9) ayant une seule fenêtre définie en son sein.
